# FASCICULE DE BREVET EUROPEEN

(11) **EP 0 847 113 B1**
(45) Date de publication et mention de la délivrance du brevet: **17.10.2001**
(21) Numéro de dépôt: 97402932.4
(22) Date de dépôt: 04.12.1997
(51) Int. Cl.: H01S 5/02, G02B 6/12

(54) **Emetteur-récepteur optique à semi-conducteur**
Optischer Halbleitersender-Empfänger
Semiconductor optical transceiver

(30) Priorité: 09.12.1996 FR 9615083
(43) Date de publication de la demande: 10.06.1998
(73) Titulaire: ALCATEL, 75008 Paris (FR)
(72) Inventeur: Jacquet, Joel, 91470 Limours (FR); Gurib, Salim, 91290 Arpajon (FR); Doukhan, Francis, 77520 Cessoy en Montois (FR); Le Quellec, Hugues, 83990 Saint-Tropez (FR)
(74) Mandataire: Fournier, Michel Robert Marie

(56) Documents cités:
- EP-A- 0 732 782
- US-A- 4 292 512
- US-A- 5 144 637
- US-A- 5 400 419
- KOREN U ET AL: "STRAINED-LAYER MULTIPLE QUANTUM WELL DISTRIBUTED BRAGG REFLECTOR LASERS WITH A FAST MONITORING PHOTODIODE" APPLIED PHYSICS LETTERS, vol. 58, no. 12, 25 mars 1991, pages 1239-1240, XP000209719

## Description

La présente invention concerne de manière générale des traitements à effectuer sur deux ondes ayant des longueurs d'onde différentes. Les traitements envisagés ici sont par exemple l'émission ou la modulation d'une telle onde, ou encore la réception d'une telle onde en vue de restituer un signal qui était porté par cette onde. Quant aux ondes à traiter elles peuvent notamment être de nature radioélectrique, accoustique ou optique.

Un dispositif à semiconducteur pour le traitement de deux ondes est décrit dans EP-A-0 732 782.

Cette invention trouve application lorsque les deux ondes en question doivent être respectivement traitées dans deux organes distincts et lorsque l'un de ces organes doit être protégé contre les ondes de l'autre organe en ce sens que, si cet organe à protéger recevait les ondes traitées ou à traiter par l'autre organe, son fonctionnement en serait perturbé. Lorsque de plus ces deux organes doivent être situés à proximité l'un de l'autre dans un milieu permettant la propagation des deux ondes en question, un premier problème est alors posé par la réalisation de la protection convenable de l'organe à protéger.

Pour résoudre ce premier problème, la présente invention a, de manière connue, pour objet un dispositif comportant :
- un premier organe de traitement dont un fonctionnement assure un traitement souhaité d'ondes ayant une première longueur d'onde,
- un deuxième organe de traitement dont un fonctionnement assure un traitement souhaité d'ondes ayant une deuxième longueur d'onde, ce fonctionnement nécessitant une protection de ce deuxième organe contre les ondes ayant la première longueur d'onde, et
- un séparateur absorbant les ondes ayant la première longueur d'onde, ce séparateur étant interposé entre les premier et deuxième organes de traitement pour réaliser ladite protection de ce deuxième organe.

Par ailleurs un deuxième problème peut aussi être posé par le fait que certains paramètres du fonctionnement des organes de traitement sont susceptibles de variations et qu'il peut alors être utile de recueillir des informations sur ces variations, par exemple pour réaliser une régulation limitant ces variations. Des organes complémentaires sont alors à prévoir pour recueillir et éventuellement exploiter de telles informations. Ils engendrent des coûts de fabrication et/ou de fonctionnement et ils peuvent présenter un encombrement gênant.

La présente invention vise à résoudre aussi ce deuxième problème d'une manière simple et économique en coût et en encombrement. Pour cela le dispositif selon l'invention comporte en outre des moyens de mesure d'absorption fournissant un signal de mesure d'absorption représentatif de la puissance des ondes absorbées par le dit séparateur de manière à constituer une information sur le fonctionnement dudit premier organe de traitement. Ces moyens de mesure d'absorption peuvent avantageusement effectuer une régulation du fonctionnement du premier organe de traitement, notamment lorsque le traitement assuré par ce fonctionnement est une émission d'ondes ayant la première longueur d'onde.

Quoique cette invention ait été décrite ci-dessus de manière générale, elle trouve application d'une manière plus particulièrement avantageuse dans le cas où les ondes en question sont de nature optique et circulent dans des fibres optiques. On sait à ce sujet que le développement considérable des services dits "multimédia" favorise le développement de réseaux interactifs à fibres optiques, notamment de réseaux locaux. Ce type de réseau nécessite l'utilisation de dispositifs d'extrémité installés chez des abonnés et ces dispositifs doivent être performants, robustes et à très bas coût pour permettre une distribution de masse des services en question. Plus précisément, en ce qui concerne leurs performances, ces dispositifs doivent assurer la réception de signaux optiques à des débits jusqu'à 622 Mbit/s avec une très faible sensibilité à la polarisation et doivent être capables d'émettre des signaux à des débits de plus de 155 Mbit/s. Une disposition avantageuse dans les réseaux en question consiste à utiliser une transmission bidirectionnelle simultanée. Les dispositifs d'extrémité doivent alors être du type appelé internationalement "transceiver", c'est à dire que chaque tel dispositif doit assurer les fonctions d'émission à une première longueur d'onde et de réception à une deuxième longueur d'onde. Il doit en outre comprendre un organe complémentaire permettant de séparer les canaux montant et descendant (donc les longueurs d'onde) et ainsi autoriser l'échange d'information dans les deux sens et simultanément.

Par ailleurs ce dispositif doit être capable de fonctionner dans des conditions difficiles, c'est à dire dans une gamme de température comprise entre -40° C et +85° C (sans utilisation de régulateur à effet Peltier). Pour assurer un bon fonctionnement de l'organe émetteur inclus dans le dispositif, une régulation doit alors être assurée par un asservissement du courant alimentant cet organe sur la puissance optique émise par lui. Cette puissance doit donc tout d'abord être mesurée. La présente invention fournit une méthode simple pour mesurer cette puissance.

A l'aide des figures schématiques ci-jointes on va décrire ci-après, à titre d'exemple, deux dispositifs réalisés selon deux modes de mise en oeuvre de cette invention, respectivement. Lorsque deux éléments jouent deux rôles identiques ou analogues dans ces deux dispositifs ils sont désignés sur ces figures par les mêmes signes de référence, éventuellemnt complétés par un chiffre 1 ou 2.

La figure 1 représente un premier dispositif selon cette invention.

La figure 2 représente un deuxième dispositif selon cette invention.

La figure 3 représente un circuit électronique assurant la régulation du courant d'alimentation de l'émetteur laser du dispositif de la figure 1.

Le premier dispositif donné en exemple comporte une puce semiconductrice 2 formée de couches se succédant en continuité cristalline de bas en haut selon une direction verticale DV définie par rapport à cette puce. Cette dernière inclut un guide d'ondes 4 s'étendant selon une direction longitudinale horizontale DL également définie par rapport à cette puce, pour guider deux ondes lumineuses ayant respectivement lesdites première et deuxième longueurs d'onde. Cette deuxième longueur d'onde est supérieure à la première. Cette puce et ce guide comportent chacun successivement selon un sens direct de la direction longitudinale DL :
- un premier segment de traitement H1 appartenant au dit premier organe de traitement,
- un segment de séparation G appartenant audit séparateur, et
- un deuxième segment de traitement H2 appartenant audit deuxième organe de traitement;

Pour éviter de surcharger les figures, lesdits segments sont désignés par les mêmes signes de référence que les organes dont ils constituent respectivement les parties incluses dans la puce 2.

Le segment de séparation de la puce 2 inclut une structure absorbante constituée de dites couches. Cette structure absorbante constitue la partie essentielle de ce segment. C'est pourquoi elle est désignée sur les figures par le mêmes signes de référence que ce segment. Il en sera de même dans la suite pour d'autres structures semiconductrices constituant les parties essentielles d'autres segments de la puce 2. Cette structure absorbante inclut successivement selon la direction verticale DV :
- une couche dopée inférieure 6 d'un premier type de conductivité (n),
- une couche non dopée 8, c'est à dire, plus précisément une couche dépourvue de dopage volontaire, et
- une couche dopée supérieure 10 du deuxième type de conductivité (p).

Cette couche non dopée est constituée d'un matériau ayant une longueur d'onde caractéristique au moins égale à la première longueur d'onde et inférieure à la deuxième longueur d'onde. Elle inclut le segment de séparation du guide d'ondes.

Le signal de mesure d'absorption fourni par les moyens de mesure d'absorption Q est constitué par l'intensité d'un courant de mesure iG passant entre les couches dopées inférieure 6 et supérieure 10 de la structure absorbante G. Ces moyens sont alimentés par une source de tension 14. Ils maintiennent de préférence une faible polarisation inverse de la structure absorbante.

Le premier organe de traitement H1 constitue typiquement un émetteur laser. Il émet deux ondes lumineuses ayant la première longueur d'onde et ayant deux puissances respectives commandées par un même courant d'alimentation iE de cet émetteur laser. Ces deux ondes constituent respectivement une onde de sortie WE se propageant dans un sens inverse de ladite direction longitudinale DL et une onde de régulation WG se propageant dans ledit sens direct de cette direction longitudinale dans le guide d'ondes 4 pour être absorbée dans le séparateur G. Les moyens de mesure d'absorption Q constituent alors un organe de régulation commandant au moins partiellement ce courant d'alimentation en fonction du signal de mesure d'absorption iG de manière à réguler la puissance de l'onde de sortie.

La longueur du segment de séparation du guide d'ondes est alors typiquement supérieure à la longueur d'onde du guide d'ondes d'une diode de régulation de type connu dont la fonction est la régulation d'un émetteur laser à semiconducteur. En effet ce segment de séparation doit assurer en outre la fonction de protection du deuxième organe de traitement. Cette longueur est typiquement de 100 µm dans le cas d'une puce à base de phosphure d'indium fonctionnant à des longueurs d'onde voisines de 1,3 et 1,5 µm. Réciproquement la polarisation électrique dans le segment de séparation, par exemple -3 V, est typiquement différente de celle qui est connue pour cette fonction de protection, car elle doit être adaptée à une mesure convenable de la puissance des ondes absorbées.

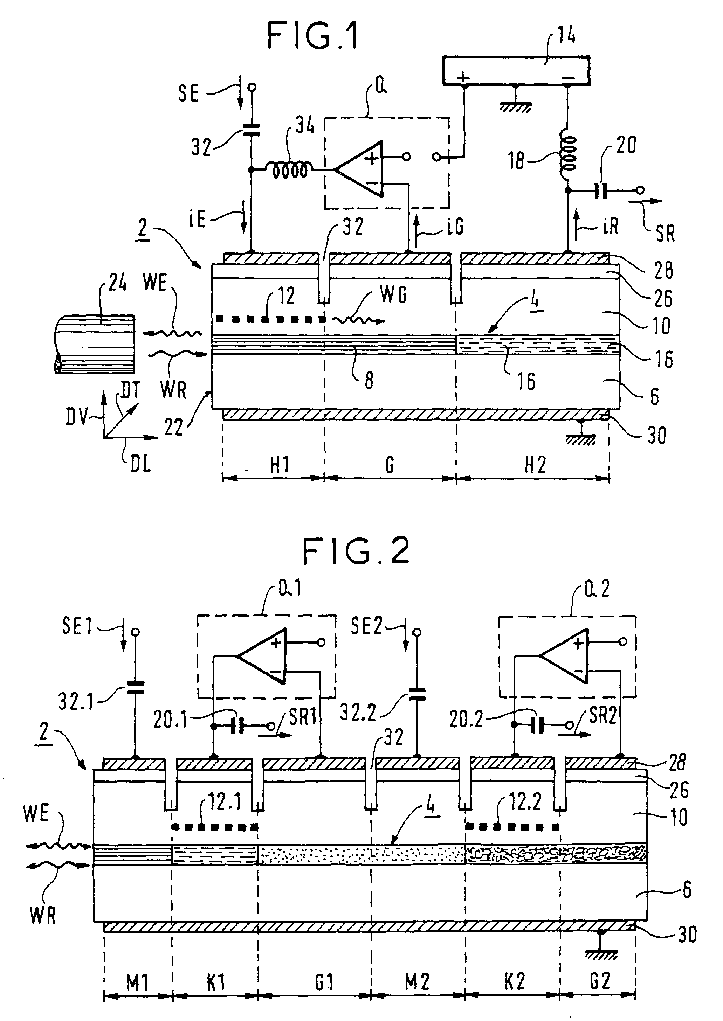

Le courant d'alimentation du laser peut porter un signal à émettre qui doit être porté par l'onde ayant la première longueur d'onde, ce qui est le cas du premier dispositif de la figure 1. Il peut aussi ne pas porter ce même signal qui est alors appliqué à un modulateur électro-optique modulant la lumière émise par l'émetteur laser, un tel modulateur étant intégré à la dite puce dans le deuxième dispositif représenté à la figure 2.

Pour constituer un émetteur laser comme indiqué ci-dessus, la puce 2 comporte typiquement dans son premier segment de traitement une structure émettrice H1 constituée des dites couches et incluant successivement ladite couche dopée inférieure 6, une couche non dopée 8, et ladite couche dopée supérieure 10. Cette couche non dopée est constituée d'un matériau ayant une longueur d'onde caractéristique égale à la première longueur d'onde. Elle inclut le premier segment de traitement du guide d'ondes 4. La puce 2 comporte en outre dans ce segment des moyens réflecteurs 12 pour inclure le premier segment de traitement du guide d'ondes dans une cavité optique longitudinale. Ces moyens réflecteurs sont classiquement constitués par un réseau de Bragg de manière à constituer un laser du type dit DFB. Le dispositif comporte en outre des moyens d'alimentation pour polariser cette structure émettrice en direct de manière à fournir le courant d'alimentation de l'émetteur laser. Ces moyens d'alimentation comportent la source de courant 14 alimentant le laser H1 par l'intermédiaire de l'organe de régulation Q.

Dans le premier dispositif donné en exemple les couches non dopées des structures émettrice et absorbante constituent une même couche 8 formée par un matériau dont la longueur d'onde caractéristique est donc égale à la dite première longueur d'onde. Dans le deuxième dispositif donné en exemple la longueur d'onde caractéristique du matériau de la couche non dopée de la structure absorbante est supérieure à la première longueur d'onde.

Toujours typiquement, la puce 2 comporte dans son deuxième segment de traitement une deuxième structure de traitement constituée de dites couches et incluant successivement selon la direction verticale DV :
- la dite couche dopée inférieure 6,
- une couche non dopée 16, et
- ladite couche dopée supérieure 10.

Cette couche non dopée a une longueur d'onde caractéristique au moins égale à la deuxième longueur d'onde. Le dispositif comporte en outre des moyens pour polariser électriquement cette deuxième structure de traitement. Ces moyens comportent la source de courant 14 qui alimente cette structure à travers une inductance de séparation 18.

Les moyens pour polariser électriquement la deuxième structure de traitement polarisent typiquement cette structure en inverse pour qu'elle constitue une structure réceptrice H2. La tension de polarisation appliquée à cette structure est typiquement comprise entre -2 et -5V. Le dispositif comporte en outre des moyens pour fournir un signal de réception SR représentatif des variations de l'intensité d'un courant iR s'écoulant entre les couches dopées inférieure 6 et supérieure 10 de cette structure en réponse à une onde d'entrée WR ayant la deuxième longueur d'onde. La structure H2 constitue ainsi une photodiode réceptrice qui est intégrée avec l'émetteur laser H1 dans la puce 2. Le signal de réception est par exemple fourni à travers un condensateur de séparation 20.

De préférence, ladite onde d'entrée WR se propage dans le sens direct de la direction longitudinale DL de sorte que l'onde d'entrée WE et l'onde de sortie WR traversent une même face de connexion 22 de la puce. Cette face permet la connexion optique du dispositif à une fibre optique 24 guidant et transmettant ces deux ondes pour raccorder le dispositif et l'abonné chez lequel il est installé aux autres organes d'un réseau interactif.

Plus particulièrement, dans le composant semiconducteur du premier dispositif donné en exemple et représenté à la figure 1, les couches de la puce semiconductrice 2 sont constituées de phosphure d'indium InP sauf indication contraire. Cette puce est munie d'électrodes sur ses deux faces principales. Ce composant comporte alors au moins six couches homogènes ou composites qui sont les suivantes de bas en haut :
- Une première couche est une électrode inférieure métallique 30.
- Une deuxième couche est un substrat mince constituant la couche dopée inférieure 6 précédemment mentionnée. Ce substrat est épais de 0,1 mm et il est dopé N à une concentration pouvant aller de 1. 10 ¹⁸ à 3. 10¹⁸ cm⁻³.
- Une troisième couche est composite en ce sens qu'elle comporte deux couches non dopées partielles formant deux fractions longitudinalement successives du guide 4 précédemment mentionné. La largeur de ce guide, par exemple 2 µm est très inférieure à la largeur de la puce 2, par exemple 100µm, ces largeurs étant mesurées selon une direction transversale perpendiculaire aux directions longitudinale et verticale précédemment mentionnées.

Dans le premier segment de traitement H1 et dans le segment de séparation G le guide 4 est constitué par une couche non dopée 8 dont la longueur d'onde caractéristique est 1 300 nm environ. Cette couche peut être constituée d'un alliage quaternaire d'arséniure et phosphure de gallium et indium Ga In As P. Son épaisseur est typiquement de 100 nm. Elle peut aussi être constituée de multi-puits quantiques qui permettent une meilleure stabilité de fonctionnement en présence de variations importantes de température. Pour mieux confiner le mode optique dans cette couche non dopée, cette dernière peut être disposée entre deux couches de matériaux ayant des longueurs d'onde caractéristiques intermédiaires entre celle de la couche non dopée et celle des couches dopées inférieure et supérieure et ayant des épaisseurs typiques comprises entre 10 et 100 nm.

Dans le deuxième segment de traitement H2 la couche non dopée 16 est réalisée de manière à absorber toute lumière dont la longueur d'onde est comprise entre 1 510 et 1 590 nm

Elle est constituée pour cela d'un alliage quaternaire Ga In As P qui présente l'avantage de permettre une réception indépendante de la polarisation de l'onde d'entrée WR. Elle peut aussi être constituée de multi-puits quantiques avec formation de contraintes mécaniques dans les puits et les barrières pour assurer l'insensibilité à la polarisation de l'onde d'entrée. L'épaisseur de cette couche est typiquement comprise entre 100 et 1 000 nm selon le rendement et la bande passante de réception souhaités.
- La quatrième couche est une couche dopée supérieure 10. Elle est dopée P à 1.10¹⁸ cm⁻³ et épaisse de 1 000 à 4 000 nm.

Au voisinage du guide 4 dans le premier segment de traitement H1 on a formé un réseau de Bragg constituant les moyens réflecteurs 12 précédemment mentionnés. Ce réseau a été réalisé par gravure périodique d'une couche d'alliage quaternaire Ga In As P immergée par reprise d'épitaxie dans le matériau de la couche 10. Cette couche est dopée P à la même concentration que la couche 10 et elle est typiquement épaisse de 40 à 100 nm. Elle est séparée de la couche 8 par une épaisseur comprise entre 50 et 300 nm pour permettre un couplage optique suffisant avec la couche 8, cette épaisseur étant occupée par le matériau de la couche 10. Ce réseau pourrait cependant être prolongé dans le segment de séparation G.
- La cinquième couche est une couche de contact 26 constituée d'un alliage quaternaire Ga In As P dopé P à 3. 10¹⁹ cm-³ par exemple pour permettre un contact ohmique avec un métal. Cette couche est épaisse de 300 nm.
- Enfin la sixième couche est une électrode supérieure métallique 28. Cette électrode est séparée en trois segments coincidant longitudinalement avec les segments H1, G et H2 de la puce et désignés par ces mêmes signes de référence. Cette séparation est réalisée par des canaux d'isolation tels que 32 gravés à travers cette électrode et la couche de contact 26 et pénétrant dans la couche dopée supérieure 10. Une implantation de protons dans la couche 10 au fond de ces canaux peut améliorer l'isolation électrique ente les segments successifs.

Un signal d'entrée de haute fréquence à transmettre SE est reçu, par l'intermédiaire d'un condensateur de séparation 32. Il module le courant d'alimentation iE de l'émetteur laser constitué par le segment H1. Cette modulation est ainsi appliquée à l'onde de sortie WE. Une inductance de séparation 34 empêche les moyens de mesure G de recevoir ce signal. En pratique les moyens de mesure Q assurent les fonctions de séparation entre haute et basse fréquence qui sont symboliquement assurées sur la figure 1 par le condensateur 32 et l'inductance 34.

L'intégration des trois segments H1, G et H2 de la puce 2 sur un même substrat 6 peut être réalisée par diverses technologies connues.

Selon la technologie dite "butt coupling" pour "couplage en bout", les étapes sont notamment les suivantes : Sur toute la longueur du substrat on fait croitre les matériaux du segment H2 jusqu'à la couche non dopée. On grave ces matériaux dans les segments H1 et G. On fait croitre les matériaux nécessaires pour constituer ces deux segments juqu'à la couche qui servira à fabriquer le réseau de Bragg 12. On effectue la gravure de cette dernière couche pour former le réseau 12. On fait croitre les matériaux de la couche dopée supérieure et de la couche de contact. Enfin on dépose l'électrode supérieure et on grave les canaux d'isolation tels que 32.

Selon une autre technologie dite de couplage évanescent on fait croitre successivement sur toute la longueur du substrat les matériaux des segments H1 et G, puis une couche non dopée constituée du matériau de la couche 16 dont la présence ne sera finalement nécessaire que dans le segment H2. Puis on élimine cette dernière couche non dopée dans les segments H1 et G. La puce finalement réalisée diffère alors de celle qui a été précédemment décrite par le fait que le segment H2 comporte les deux couches non dopées en superposition.

Selon enfin une autre technologie connue dite "SAG" pour Selective Area Growth, c'est à dire "croissance de surface sélective", les couches non dopées des trois segments sont constituées de multi-puits quantiques et sont réalisées en une seule étape de croissance épitaxiale. Des fenêtres sont percées pour cela dans des masques d'oxyde et la différence à obtenir entre les longueurs d'onde caractéristiques des couches 8 et 16 est obtenue en donnant des valeurs différentes aux largeurs de ces fenêtres.

Le guide 4 peut être délimité en largeur en une seule étape de gravure sur toute sa longueur. Dans l'exemple précédemment décrit il est du type connu dit "BRS" pour Buried Ridge Structure c'est à dire structure à ruban enterré. Il pourrait aussi être du type connu dit "Ridge" c'est à dire à ruban gravé. Dans ce dernier cas le confinement du mode optique selon la direction transversale n'est pas assuré par la limitation de la largeur des couches non dopées, mais par celle d'un ruban formé pour cela dans une couche sur jacente en un matériau à indice de réfraction relativement élevé.

Le deuxième dispositif selon l'invention est généralement analogue au premier mais il en diffère par plusieurs dispositions indiquées ci-après.

Il comporte une succession de six segments M1, K1, G1, M2, K2, et G2. Les segments K1 et K2 sont respectivement analogues aux segments H1 et H2 du premier dispositif sauf sur deux points : Premièrement ils peuvent chacun assurer des fonctions d'émission et/ou de réception. Deuxièment, dans leur fonction d'émission, ils ne jouent pas le rôle de modulateurs, ces rôles étant respectivement joués par les segments de modulation M1 et M2. Le segment G1 assure à la fois une fonction de protection des segments M2, K2 et G2 contre les ondes ayant la première longueur d'onde et une fonction de régulation de l'émetteur laser constitué par le segment K1 muni d'un réseau de Bragg 12-1. Le segment G2 assure seulement une fonction de régulation du laser constitué par le segment K2 à l'aide d'un réseau de Bragg 12-2.

Les segments de modulation M1 et M2 sont polarisés par des moyens non représentés sous une tension inverse de -3 V environ. Les longueurs d'onde caractéristiques des matériaux des couches non dopées longitudinalement successives constituant le guide d'ondes 4 sont les suivantes, environ :
- 280 nm dans le segment M1,
- 300 nm dans le segment K1,
- 500 nm dans les segments G1 et M2, et
- 550 nm dans les segments K2 et G2.

Les signaux d'entrée SE1 et SE2 sont reçus à travers des condensateurs 32-1 et 32-2 dans les segments M1 et M2, et les signaux de sortie SR1 et SR2 sont fournis à travers les condensateurs 20-1 et 20-2 à partir des segments K1 et K2, respectivement.

L'intégration de ces six segments est avantageusement réalisée par la technologie SAG, du moins dans le cas où il est acceptable que la réception soit sensible à la polarisation de l'onde ou des ondes d'entrée.

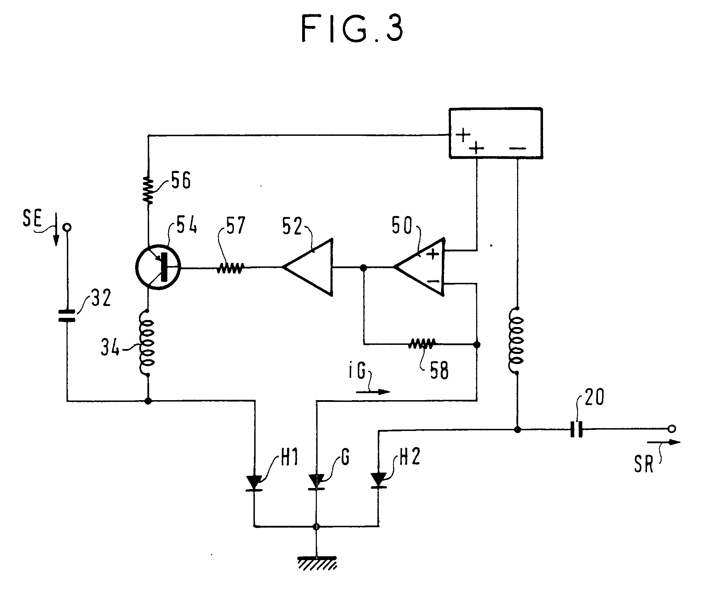

La figure 3 représente à titre d'exemple un circuit électronique d'asservissement assurant la régulation de l'organe émetteur du premier dispositif donné en exemple et constituant en même temps les moyens de mesure Q précédemment mentionnés. Les organes constitués par les segments H1, G et H2 sont représentés sous la forme de diodes. Le circuit Q comporte un comparateur 50 qui reçoit sur son entrée inversée le signal de mesure iG fourni par la diode G. Ce comparateur est suivi d'un inverseur 52 pour commander la base d'un transistor PNP 54 qui commande le courant d'alimentation de la diode laser constituée par le segment H1. Des résistances de liaison sont représentées en 56, 57 et 58.

## Revendications

1. Un dispositif, notamment à semi conducteur, pour le traitement de deux ondes, notamment lumineuses, ce dispositif comportant :
- un premier organe de traitement (H1) dont un fonctionnement assure un traitement souhaité d'ondes (WE) ayant une première longueur d'onde,
- un deuxième organe de traitement (H2) dont un fonctionnement assure un traitement souhaité d'ondes (WR) ayant une deuxième longueur d'onde, ce fonctionnement nécessitant une protection de ce deuxième organe contre les ondes ayant la première longueur d'onde, et
- un séparateur (G) absorbant les ondes ayant la première longueur d'onde, ce séparateur étant interposé entre les premier et deuxième organes de traitement pour réaliser ladite protection de ce deuxième organe,
ce dispositif étant **caractérisé par le fait qu'**il comporte en outre des moyens de mesure d'absorption (Q) fournissant un signal de mesure d'absorption (iG) représentatif de la puissance des ondes absorbées par le dit séparateur de manière à constituer une information sur le fonctionnement dudit premier organe de traitement.

2. Dispositif selon la revendication 1, ce dispositif étant **caractérisé par le fait que** lesdits moyens de mesure d'absorption (Q) assurent une régulation du fonctionnement dudit premier organe de traitement (H1), le dit traitement assuré par ce fonctionnement étant une émission d'ondes (WE) ayant ladite première longueur d'onde.

3. Dispositif selon la revendication 1, ce dispositif comportant une puce semiconductrice (2) formée de couches se succédant en continuité cristalline de bas en haut selon une direction verticale (DV) de cette puce, cette puce incluant un guide d'ondes (4) s'étendant selon une direction longitudinale horizontale (DL) de cette puce pour guider deux ondes lumineuses ayant respectivement lesdites première et deuxième longueurs d'onde, cette deuxième longueur d'onde étant supérieure à la première, cette puce et ce guide comportant chacun successivement selon un sens direct de ladite direction longitudinale (DL) :
- un premier segment de traitement (H1) appartenant au dit premier organe de traitement,
- un segment de séparation (G) appartenant audit séparateur, et
- un deuxième segment de traitement (H2) appartenant audit deuxième organe de traitement, le dit segment de séparation de la puce incluant une structure absorbante constituée de dites couches, cette structure incluant successivement selon ladite direction verticale (DV) :
- une couche dopée inférieure (6) d'un premier type de conductivité,
- une couche non dopée (8), et
- une couche dopée supérieure (10) du deuxième type de conductivité,
cette couche non dopée étant constituée d'un matériau ayant une longueur d'onde caractéristique au moins égale à ladite première longueur d'onde et inférieure à ladite deuxième longueur d'onde, cette couche non dopée incluant ledit segment de séparation dudit guide d'ondes,
le dit signal de mesure d'absorption fourni par les moyens de mesure d'absorption (Q) étant constitué par l'intensité d'un courant de mesure (iG) passant entre lesdites couches dopées inférieure (6) et supérieure (10) de cette structure absorbante (G).

4. Dispositif selon la revendication 3, ledit premier organe de traitement (H1) étant un émetteur laser émettant deux ondes lumineuses ayant ladite première longueur d'onde et ayant deux puissances respectives commandées par un même courant d'alimentation (iE) de cet émetteur laser, ces deux ondes constituant respectivement une onde de sortie (WE) se propageant dans un sens inverse de ladite direction longitudinale (DL) et une onde de régulation (WG) se propageant dans ledit sens direct de cette direction longitudinale dans ledit guide d'ondes (4) pour être absorbée dans ledit séparateur (G), lesdits moyens de mesure d'absorption (Q) constituant un organe de régulation commandant au moins partiellement ce courant d'alimentation en fonction dudit signal de mesure d'absorption (iG) de manière à réguler ladite puissance de l'onde de sortie.

5. Dispositif selon la revendication 4, ladite puce (2) comportant dans son premier segment de traitement une structure émettrice (H1) constituée de dites couches et incluant successivement ladite couche dopée inférieure (6), une couche non dopée (8), et ladite couche dopée supérieure (10), cette couche non dopée étant constituée d'un matériau ayant une longueur d'onde caractéristique égale à la dite première longueur d'onde, cette couche non dopée incluant ledit premier segment de traitement du guide d'ondes (4), cette puce comportant en outre dans ce segment des moyens réflecteurs (12) pour inclure le dit premier segment de traitement du guide d'ondes dans une cavité optique longitudinale, ledit dispositif comportant en outre des moyens d'alimentation (14,Q) pour polariser ladite structure émettrice en direct de manière à fournir ledit courant d'alimentation de l'émetteur laser.

6. Dispositif selon la revendication 4, ladite puce comportant dans son dit deuxième segment de traitement une deuxième structure de traitement (H2) constituée de dites couches et incluant successivement selon la direction verticale (DV) :
- la dite couche dopée inférieure (6),
- une couche non dopée (16) et
- ladite couche dopée supérieure (10),
cette couche non dopée ayant une longueur d'onde caractéristique au moins égale à ladite deuxième longueur d'onde, ledit dispositif comportant en outre des moyens (14, 18) pour polariser électriquement cette deuxième structure de traitement.

7. Dispositif selon la revendication 6, lesdits moyens pour polariser électriquement ladite deuxième structure de traitement polarisant cette structure en inverse pour qu'elle constitue une structure réceptrice (H2), ledit dispositif comportant en outre des moyens pour fournir un signal de réception (SR) représentatif des variations de l'intensité d'un courant iR s'écoulant entre lesdites couches dopées inférieure (6) et supérieure (10) de cette structure en réponse à une onde d'entrée (WR) ayant la dite deuxième longueur d'onde.

8. Dispositif selon la revendication 7, ladite onde d'entrée (WR) se propageant dans ledit sens direct de la direction longitudinale (DL) de sorte que l'onde d'entrée (WE) et l'onde de sortie (WR) traversent une même face de connexion (22) de la puce.

9. Dispositif selon la revendication 3, ladite puce (2) étant constituée à base d'arséniure de gallium et lesdites première et deuxième longueurs d'onde étant respectivement voisines de 1300 et 1550 nm.

## Patentansprüche

1. Vorrichtung, insbesondere Halbleitervorrichtung, für die Verarbeitung von zwei Wellen, insbesondere Lichtwellen, welche umfasst:
- ein erstes Verarbeitungsorgan (H1), dessen Betrieb eine gewünschte Verarbeitung von Wellen (WE) mit einer ersten Wellenlänge gewährleistet,
- einem zweiten Verarbeitungsorgan (H2), dessen Betrieb eine gewünschte Verarbeitung von Wellen (WR) mit einer zweiten Wellenlänge gewährleistet, wobei dieser Betrieb einen Schutz dieses zweiten Organs vor den Wellen mit der ersten Wellenlänge erfordert, und
- einem Separator (G), der die Wellen mit der ersten Wellenlänge absorbiert, wobei dieser Separator zwischen dem ersten und dem zweiten Verarbeitungsorgan angeordnet ist, um den Schutz dieses zweiten Organs zu bewirken,
**dadurch gekennzeichnet, dass** sie ferner Absorptionsmessmittel (Q) umfasst, die ein Absorptionsmesssignal (iG) liefern, das für die Leistung der von dem Separator absorbierten Wellen repräsentativ ist, um eine Information über den Betrieb des ersten Verarbeitungsorgans zu bilden.

2. Vorrichtung nach Anspruch 1, **dadurch gekennzeichnet, dass** die Absorptionsmessmittel (Q) eine Regelung des Betriebs des ersten Verarbeitungsorgans (H1) gewährleisten, wobei die von diesem Betrieb gewährleistete Verarbeitung eine Emission von Wellen (WE) mit der ersten Wellenlänge ist.

3. Vorrichtung nach Anspruch 1, mit einem Halbleiterchip (2), der aus in einer vertikalen Richtung (DV) von unten nach oben in kristalliner Kontinuität aufeinanderfolgenden Schichten gebildet ist, wobei dieser Chip einen Wellenleiter (4) umfasst, der sich in einer horizontalen Längsrichtung (DL) dieses Chips erstreckt, um zwei Wellen, die jeweils die erste und die zweite Wellenlänge haben, zu leiten, wobei diese zweite Wellenlänge größer als die erste ist und der Chip und der Wellenleiter jeweils gleichsinning in Längsrichtung (DL) aufweisen:
- ein erstes Verarbeitungssegment (H1), das zu dem ersten Verarbeitungsorgan gehört,
- ein Trennsegment (G), das zu dem Separator gehört, und
- ein zweites Verarbeitungssegment (H2), das zu dem zweiten Verarbeitungsorgan gehört, wobei das Trennsegment des Chips eine absorbierende Struktur umfasst, die aus diesen Schichten gebildet ist, wobei die Struktur nacheinander in der vertikalen Richtung (DV) umfasst:
- eine untere dotierte Schicht (6) mit einem ersten Leitfähigkeitstyp,
- eine nicht dotierte Schicht (8) und
- eine obere dotierte Schicht (10) mit dem zweiten Leitfähigkeitstyp,
wobei die nicht dotierte Schicht aus einem Material mit einer charakteristischen Wellenlänge von wenigstens gleich der ersten Wellenlänge und weniger als der zweiten Wellenlänge gebildet ist, wobei diese nicht dotierte Schicht das Trennsegment des Wellenleiters umfasst, wobei das von den Absorptionsmessmitteln (Q) gelieferte Absorptionsmesssignal gebildet ist durch die Stärke eines Messstroms (iG), der zwischen der unteren (6) und der oberen (10) dotierten Schicht der absorbierenden Struktur (G) fließt.

4. Vorrichtung nach Anspruch 3, bei der das erste Verarbeitungsorgan (H1) ein Lasersender ist, der zwei Lichtwellen mit der ersten Wellenlänge und jeweils zwei durch einen gleichen Versorgungsstrom (iE) des Lasersenders gesteuerten Leistungen emittiert, wobei diese zwei Wellenlängen jeweils eine sich gegensinning zu der Längsrichtung (DL) ausbreitende Ausgangswelle (WE) und eine Regelwelle (WG), die sich gleichsinning zu dieser Längsrichtung in dem Wellenleiter (4) ausbreitet, um in dem Separator (G) absorbiert zu werden, darstellen, wobei die Absorptionsmessmittel (Q) ein Regelorgan darstellen, das wenigstens teilweise den Versorgungsstrom in Abhängigkeit von dem Absorptionsmesssignal (iG) steuert, um die Leistung der Ausgangswelle zu regeln.

5. Vorrichtung nach Anspruch 4, bei der der Chip (2) in seinem ersten Verarbeitungssegment eine durch die Schichten gebildete Senderstruktur (H1) umfasst, die nacheinander die untere dotierte Schicht (6), eine nicht dotierte Schicht (8) und die obere dotierte Schicht (10) umfasst, wobei die nicht dotierte Schicht aus einem Material mit einer charakteristischen Wellenlänge gleich der ersten Wellenlänge gebildet ist, wobei diese nicht dotierte Schicht das erste Verarbeitungssegment des Wellenleiters (4) umfasst, wobei der Chip ferner in diesem Segment Reflektormittel (12) zum Einschließen des ersten Verarbeitungssegments des Wellenleiters in einem longitudinalen optischen Hohlraum aufweist und die Vorrichtung ferner Versorgungsmittel (14Q) zum gleichsinnigen Vorspannen der Senderstruktur umfasst, um den Versorgungsstrom des Lasersenders zu liefern.

6. Vorrichtung nach Anspruch 4, bei der der Chip in seinem zweiten Verarbeitungssegment eine zweite Verarbeitungsstruktur (H2) aufweist, die aus den besagten Schichten gebildet ist und nacheinander in der vertikalen Richtung (DV) umfasst:
- die untere dotierte Schicht (6),
- eine nicht dotierte Schicht (16), und
- die obere dotierte Schicht (10),
wobei die nicht dotierte Schicht eine charakteristische Wellenlänge wenigstens gleich der zweiten Wellenlänge hat, wobei die Vorrichtung ferner Mittel (14, 18) zum elektrischen Vorspannen dieser zweiten Verarbeitungsstruktur umfasst.

7. Vorrichtung nach Anspruch 6, bei der die Mittel zum elektrischen Vorspannen der zweiten Verarbeitungsstruktur diese gegensinning vorspannen, so dass sie eine Empfängerstruktur (H2) bildet, wobei die Vorrichtung ferner Mittel zum Liefern eines Empfangssignals (SR) umfasst, das für Schwankungen der Intensität eines Stroms iR repräsentativ ist, der zwischen der unteren (6) und der oberen (10) dotierten Schicht dieser Struktur in Reaktion auf eine Eingangswelle (WR) mit der zweiten Wellenlänge fließt.

8. Vorrichtung nach Anspruch 7, bei der die Eingangswelle (WR) sich gleichsinnig zu der Längsrichtung (DL) ausbreitet, so dass die Eingangswelle (WE) und die Ausgangswelle (WR) eine gleiche Verbindungsfläche (22) des Chips durchqueren.

9. Vorrichtung nach Anspruch 3, bei der der Chip (2) auf Grundlage von Galliumarsenid gebildet ist und die erste und zweite Wellenlänge jeweils bei 1300 und 1550 nm liegen.

## Claims

1. A device, in particular a semiconductor device, for processing two waves, in particular light waves, said device including:
a first processing member (H1) which operates such that desired processing is performed on waves (WE) having a first wavelength;
a second processing member (H2) which operates such that desired processing is performed on waves (WR) having a second wavelength, operation of said second processing member requiring protection to be provided for said second member against waves having the first wavelength; and
a separator (G) absorbing the waves having the first wavelength, which separator is interposed between the first processing member and the second processing member in order to provide said second member with said protection;
said device being **characterized by** the fact that it further includes absorption measurement means (Q) delivering an absorption measurement signal (iG) representative of the power of the waves absorbed by said separator so as to constitute information on operation of said first processing member.

2. A device according to claim 1, said device being **characterized by** the fact that said absorption measurement means (Q) regulate operation of said first processing member (H1), said processing performed by said operation being emission of waves (WE) having said first wavelength.

3. A device according to claim 1, said device including a semiconductor chip (2) made up of layers succeeding one another in crystal continuity from bottom to top in a vertical direction (DV) of the chip, said chip including a waveguide (4) extending in a horizontal longitudinal direction (DL) of the chip for guiding two light waves respectively having said first wavelength and said second wavelength, the second wavelength being longer than the first wavelength, both said chip and said guide including the following in succession going forwards along said longitudinal direction (DL):
a first processing segment (H1) belonging to said first processing member;
a separation segment (G) belonging to said separator; and
a second processing segment (H2) belonging to said second processing member, said separation segment of the chip including an absorbant structure made up of said layers, said structure including the following in succession in said vertical direction (DV):
a bottom doped layer (6) of a first conductivity type;
a non-doped layer (8); and
a top doped layer (10) of the second conductivity type;
the non-doped layer being made of a material having a characteristic wavelength greater than or equal to said first wavelength and less than said second wavelength, the non-doped layer including said separation segment of said waveguide; and
said absorption measurement signal delivered by the absorption measurement means (Q) being constituted by the magnitude of a measurement current (iG) flowing between said bottom doped layer (6) and said top doped layer (10) of the absorbant structure (G).

4. A device according to claim 3, said first processing member (H1) being a laser emitter emitting two light waves having said first wavelength and having respective power values controlled by the same power supply current (iE) of the laser emitter, the two waves respectively constituting an output wave (WE) propagating backwards along said longitudinal direction (DL), and a regulation wave (WG) propagating forwards along said longitudinal direction in said waveguide (4) so as to be absorbed in said separator (G), said absorption measurement means (Q) constitute a regulating member at least partially controlling the power supply current as a function of said absorption measurement signal (iG) so as to regulate said power of the output wave.

5. A device according to claim 4, said chip (2) including, in its first processing segment, an emitter structure (H1) constituted by said layers, and successively including said bottom doped layer (6), a non-doped layer (8), and said top doped layer (10), the non-doped layer being made of a material having a characteristic wavelength equal to said first wavelength, the non-doped layer including said first processing segment of the waveguide (4), the chip further including, in this segment, reflector means (12) for including said first processing segment of the waveguide in a longitudinal optical cavity, said device further including power supply means (14, Q), for forwardly biasing said emitter structure so as to deliver said power supply current for powering the laser emitter.

6. A device according to claim 4, said chip including, in its second processing segment, a second processing structure (H2) made up of said layers and including the following in succession in the vertical direction (DV):
said bottom doped layer (6);
a non-doped layer (16); and
said top doped layer (10);
said non-doped layer having a characteristic wavelength not less than said second wavelength, said device further including means (14, 18) for electrically biasing said second processing structure.

7. A device according to claim 6, said means for electrically biasing said second processing structure reversely biasing the structure so that it constitutes a receiver structure (H2), said device further including means for delivering a receive signal (SR) representative of the variations in a current iR flowing between said bottom doped layer (6) and said top doped layer (10) of said structure in response to an input wave (WR) having said second wavelength.

8. A device according to claim 7, said input wave (WR) propagating forwards along said longitudinal direction (DL) so that the input wave (WE) and the output wave (WR) pass through the same connection face (22) of the chip.

9. A device according to claim 3, said chip (2) being based on gallium arsenide, and said first and second wavelengths lying respectively in the vicinities of 1,300 nm and of 1,550 nm.
